# EUROPÄISCHE PATENTSCHRIFT

(11) **EP 1 658 661 B1**
(45) Veröffentlichungstag und Bekanntmachung des Hinweises auf die Patenterteilung: **29.10.2008**
(21) Anmeldenummer: 04762631.2
(22) Anmeldetag: 09.08.2004
(51) Int. Cl.: H01R 33/945

(54) **LAMPENSOCKEL FÜR EINE HOCHDRUCKENTLADUNGSLAMPE UND HOCHDRUCK ENTLADUNGSLAMPE**
LAMP BASE FOR A HIGH-PRESSURE DISCHARGE LAMP, AND CORRESPONDING HIGH-PRESSURE DISCHARGE LAMP
CULOT DE LAMPE POUR LAMPE A DECHARGE A HAUTE PRESSION ET LAMPE A DECHARGE A HAUTE PRESSION CORRESPONDANTE

(30) Priorität: 26.08.2003 DE 10339591
(43) Veröffentlichungstag der Anmeldung: 24.05.2006
(73) Patentinhaber: Patent-Treuhand-Gesellschaft für elektrische Glühlampen mbH, 81543 München (DE)
(72) Erfinder: BEHR, Gerhard, 89174 Altheim (DE); BURKHARDT, Matthias, 85662 Hohenbrunn (DE); HELBIG, Peter, 89567 Sontheim (DE); RUPP, Arnulf, 82041 Oberhaching (DE)
(74) Vertreter: Raiser, Franz
(86) Internationale Anmeldenummer: PCT/DE2004/001786
(87) Internationale Veröffentlichungsnummer: WO 2005/022576

(56) Entgegenhaltungen:
- EP-A- 0 855 851
- EP-A- 0 886 286
- EP-A- 1 189 314
- WO-A-00/59269

## Beschreibung

Die Erfindung betrifft einen Lampensockel für Hochdruckentladungslampe gemäß des Oberbegriffs des Patentanspruchs 1 und eine Hochdruckentladungslampe gemäß des Oberbegriffs des Patentanspruchs 4.

### I. Stand der Technik

Ein derartiger Lampensockel ist in der Offenlegungsschrift WO 02/27746 A1 offenbart. Diese Schrift beschreibt einen Lampensockel für eine Hochdruckentladungslampe, der eine Montageplatine mit darauf angeordneten elektronischen Bauteilen einer Zündvorrichtung oder eines Betriebsgerätes der Hochdruckentladungslampe aufweist.

Die WO 00/59269 A offenbart einen Lampensockel für eine Hochdruckentladungslampe mit einer im Lampensockel angeordneten Zündvorrichtung.

### II. Darstellung der Erfindung

Es ist die Aufgabe der Erfindung, einen Lampensockel für eine Hochdruckentladungslampe und eine Hochdruckentladungslampe mit einer darin angeordneten Montageplatine bereitzustellen, die eine sichere Kontaktierung einer Stromzuführung der Hochdruckentladungslampe mit auf der Montageplatine angeordneten elektronischen Bauteilen gewährleistet.

Diese Aufgabe wird erfindungsgemäß durch die Merkmale des Patentanspruchs 1 bzw. 4 gelöst. Besonders vorteilhafte Ausführungen der Erfindung sind in den abhängigen Patentansprüchen beschrieben.

Der erfindungsgemäße Lampensockel besitzt eine im Lampensockel angeordnete Montageplatine für elektronische Bauteile, wobei die Montageplatine erfindungsgemäß ein in die Montageplatine eingebettetes ringförmiges metallisches Kontaktelement aufweist. Durch die Ringöffnung kann ein Ende einer Lampenstromzuführung hindurchgeführt werden, um das Ende der Stromzuführung auf der Rückseite der Montageplatine mit dem metallischen Kontaktelement, das durch Leiterbahnen mit auf der Montageplatine montierten elektronischen Bauteilen verbunden ist, zu verschweißen oder zu verlöten. Dadurch wird eine sichere mechanische und elektrische Kontaktierung der Stromzuführung mit dem Kontaktelement gewährleistet.

Das vorgenannte metallische Kontaktelement ist vorzugsweise entweder in das elektrisch isolierende Kunststoffmaterial der Montageplatine eingespritzt oder aber in eine passgerecht auf die Gestalt des Kontaktelementes abgestimmte Aussparung der Montageplatine eingesetzt.

Um ein problemloses Hindurchführen einer Stromzuführung durch die Ringöffnung des ringförmigen metallischen Kontaktelementes zu ermöglichen, ist der Innendurchmesser des ringförmigen Kontaktelementes in vorteilhafter Weise auf die Dicke oder den Durchmesser der Stromzuführung abgestimmt. Vorzugsweise ist das ringförmige metallische Kontaktelement im Bereich seiner Ringöffnung trichterförmig ausgebildet, um die Lampenstromzuführung besser durch die Ringöffnung hindurchführen zu können. Der trichterförmige Bereich des Kontaktelementes wirkt als Einfädelungshilfe für die Lampenstromzuführung. Gemäß des bevorzugten Ausführungsbeispiels der Erfindung, weist die Montageplatine mehrere Durchbrüche auf, die zur elektrischen Isolierung von auf der Montageplatine angeordneten, Hochspannung führenden elektronischen Bauteilen dienen. Insbesondere kann dadurch die elektrische Isolierung der Funkenstrecke und des Zündkondensators einer Impulszündvorrichtung von den anderen elektronischen Bauteilen sowie von der mit dem ringförmigen metallischen Kontaktelement verbundenen Stromzuführung verbessert werden.

Die erfindungsgemäße Hochdruckentladungslampe weist einen Lampensockel mit einer im Lampensockel angeordneten Montageplatine für elektronische Bauteile auf, wobei die Montageplatine erfindungsgemäß mit einem in die Montageplatine eingebetteten ringförmigen metallischen Kontaktelement ausgestattet ist. Wie bereits oben erwähnt wurde, wird dadurch eine sichere mechanische und elektrische Kontaktierung einer Stromzuführung der Hochdruckentladungslampe mit dem Kontaktelement gewährleistet. Die erfindungsgemäße Hochdruckentladungslampe weist außerdem vorzugsweise die gleichen Merkmale auf, die bereits oben im Zusammenhang mit dem erfindungsgemäßen Lampensockel und dessen Vorteilen beschrieben wurden.

### III. Beschreibung des bevorzugten Ausführungsbeispiels

Nachstehend wird die Erfindung anhand eines bevorzugten Ausführungsbeispiels näher erläutert. Es zeigen:
- Figur 1: Eine Draufsicht auf die im Lampensockel einer Hochdruckentladungslampe angeordneten Montageplatine gemäß eines bevorzugten Ausführungsbeispiels der Erfindung
- Figur 2: Details des ringförmigen Kontaktelementes der in Figur 1 dargestellten Montageplatine
- Figur 3: Eine Draufsicht auf das Sockelaußenteil gemäß des bevorzugten Ausführungsbeispiels der Erfindung
- Figur 4: Eine Seitenansicht der Hochdruckentladungslampe gemäß des bevorzugten Ausführungsbeispiels der Erfindung

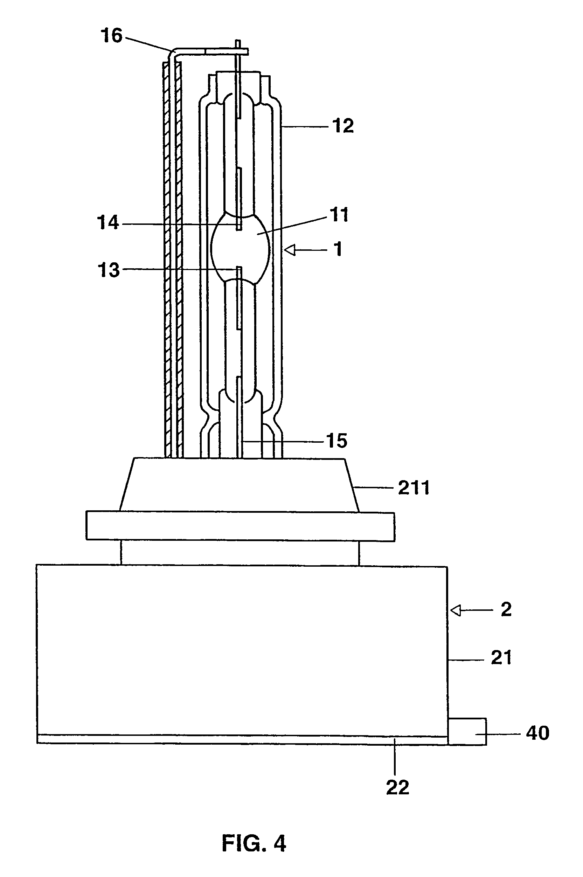

In Figur 4 ist eine Hochdruckentladungslampe gemäß des bevorzugten Ausführungsbeispiels der Erfindung abgebildet. Bei dieser Hochdruckentladungslampe handelt es sich um eine Metallhalogenid-Hochdruckentladungslampe mit einer im Lampensockel integrierten Impulszündvorrichtung. Diese Hochdruckentladungslampe ist zur Verwendung als Lichtquelle in einem Kraftfahrzeugscheinwerfer vorgesehen.

Die Hochdruckentladungslampe besitzt ein von einem gläsernen Außenkolben 12 umschlossenes Entladungsgefäß 11 aus Quarzglas mit darin angeordneten Elektroden 13, 14 zum Erzeugen einer Gasentladung. Die Elektroden 13, 14 sind jeweils mit einer aus dem Entladungsgefäß 11 herausgeführten Stromzuführung 15 bzw. 16 verbunden, über die sie mit elektrischer Energie versorgt werden. Die aus dem Entladungsgefäß 11 und dem Außenkolben 12 bestehenden Baueinheit 1 ist im Lampensockel 2 fixiert. Der Lampensockel 2 umfasst ein Sockelaußenteil 21 und einen Deckel 22, der die Kammern des Sockelaußenteils 21 verschließt, sowie eine Steckerbuchse 40 zur Spannungsversorgung der Hochdruckentladungslampe.

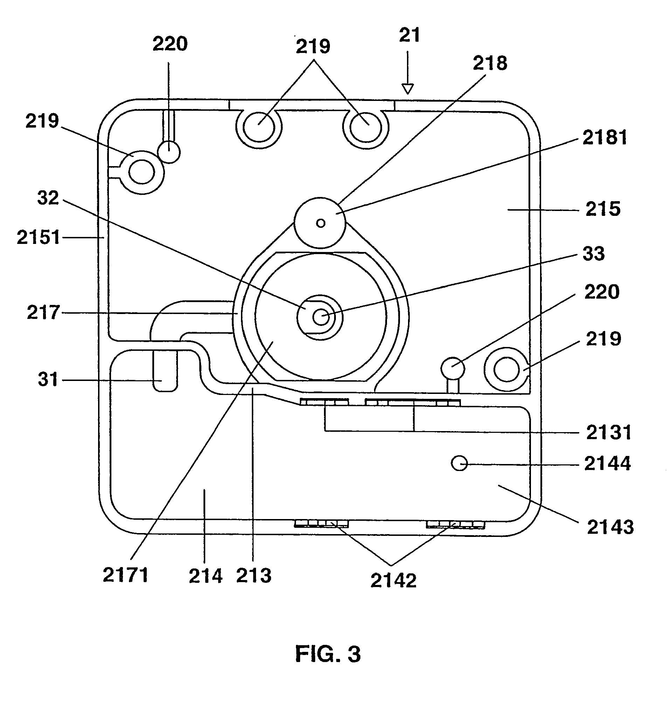

Das in Figur 3 abgebildete Sockelaußenteil 21 besitzt einen im wesentlichen quadratischen Querschnitt. Der Innenraum des Sockelaußenteils 21 wird durch eine Trennwand 213 in zwei unterschiedlich große Kammern 214, 215 unterteilt. Die kleinere, erste Kammer 214 ist zur Aufnahme eines Stabkerntransformators (nicht abgebildet) vorgesehen, der als Zündtransformator für die im Lampensockel 2 untergebrachte Impulszündvorrichtung der Hochdruckentladungslampe dient. In der größeren, zweiten Kammer 215 sind die restlichen Komponenten der Impulszündvorrichtung (nicht abgebildet) angeordnet. In dem Sockelaußenteil 21 ist ein elektrisches Kontaktelement eingebettet. Das erste Ende 31 des elektrischen Kontaktelementes erstreckt sich in die erste Kammer 214 und ist nach der Montage des Stabkerntransformators mit dem Hochspannung führenden Zündspannungsausgang des Stabkerntransformators verschweißt. Das zweite Ende 32 des elektrischen Kontaktelementes, das mit einer durchgehenden Bohrung 33 für die innere Stromzuführung 15 der Hochdruckentladungslampe versehen ist, erstreckt sich in die zweite Kammer 215. In dem Sockelaußenteil 21 ist eine Wanne 2171 vorgesehen, die durch einen hohlzylindrischen Steg 217 begrenzt wird. Das zweite Ende 32 des Kontaktelementes bildet einen Teil des Wannenbodens. Nach dem Verschweißen der inneren Stromzuführung 15 mit dem zweiten Ende 32 des Kontaktelementes wird die Wanne 2171 mit einer elektrisch isolierenden Vergussmasse ausgefüllt, so dass die Schweißstelle zwischen den beiden Lampenkomponenten 15, 32 in der Vergussmasse eingebettet ist. Das in den Sockel 2 zurückgeführte Ende der aus dem sockelfernen Ende des Entladungsgefäßes 11 herausragenden äußeren Stromzuführung 16 erstreckt sich in den hohlzylindrischen Steg 218, der ebenfalls an dem Sockelaußenteil 21 angeformt ist. Weitere hohlzylindrische Stege 219 dienen zur Befestigung der Steckerbuchse 40 und des Deckels 22.

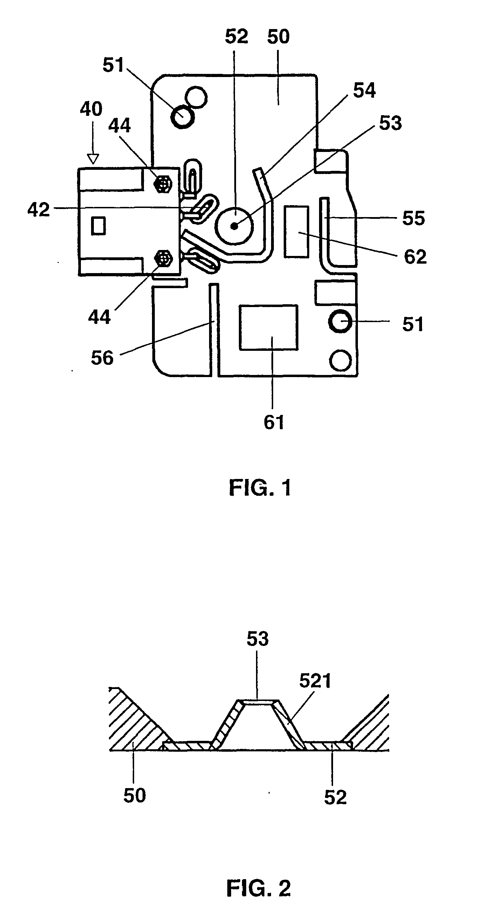

In Figur 1 ist eine Montageplatine 50 dargestellt, welche die zweite Kammer 215 des Sockelaußenteils 21 abdeckt. Auf der Montageplatine 50 sind als elektrischer Anschluss der Hochdruckentladungslampe dienende Steckerbuchse 40 und der Zündkondensator 61, die Funkenstrecke 62 sowie weitere elektronische Bauteile einer Zündvorrichtung der in Figur 4 abgebildeten Hochdruckentladungslampe angeordnet. Die drei Kontaktstifte 42 der Steckerbuchse 40 sind jeweils über auf der Montageplatine 50 angeordnete Leiterbahnen (nicht abgebildet) mit dem in der Montageplatine eingebetteten ringförmigen metallischen Kontaktelement 52, dem Zündkondensator 61, der Funkenstrecke 62 oder anderen elektronischen Bauteilen verbunden. Details des ringförmigen Kontaktelementes 52 sind in der Figur 2 gezeigt. Das ringförmige Kontaktelement 52 besteht aus einem Metallblech, beispielsweise aus Kupfer, Stahl oder einer Kupfer- oder Stahllegierung. Es besitzt einen trichterförmigen Bereich 521. Das heißt, die Ringöffnung 53 des Kontaktelementes 52 ist trichterförmig ausgebildet. Die Montageplatine 50 wird derart auf das Sockelaußenteil 21 aufgesetzt, dass die auf der Montageplatine 50 montierten Bauteile 61, 62 der Zündvorrichtung in die zweite Kammer 215 des Sockelaußenteils hineinragen und die Zapfen 44 der Steckerbuchse 40 in die Hohlstege 219 des Sockelaußenteils 21 sowie die Stege 220 in die Durchbrüche 51 der Montageplatine greifen. Das aus dem Hohlsteg 218 des Sockelaußenteils 21 herausragende Ende der äußeren Stromzuführung 16 wird dabei durch die Ringöffnung 53 des Kontaktelementes 52 hindurchgeführt und auf der Rückseite der Montageplatine 50 mit dem Kontaktelement 52 verschweißt oder verlötet. Die Montageplatine 50 ist als Kunststoffspritzgussteil ausgebildet, in dem das ringförmige Kontaktelement 52 eingespritzt ist. Zur elektrischen Isolierung des ringförmigen Kontaktelementes 52 und anderer Bauteile der Zündvorrichtung von dem Zündkondensator 61 und der Funkenstrecke 62 sind in der Montageplatine mehrere Durchbrüche 54, 55, 56 vorgesehen.

Der Deckel 22 verschließt beide Kammern 214, 215 des Sockelaußenteils 21 und deckt die Rückseite der Montageplatine 50 ab.

## Patentansprüche

1. Lampensockel für eine Hochdruckentladungslampe mit einer im Lampensockel (2) angeordneten Montageplatine (50) für elektronische Bauteile (61, 62), wobei die Montageplatine (50) ein in die Montageplatine (50) eingebettetes ringförmiges metallisches Kontaktelement (52) aufweist
**dadurch gekennzeichnet, dass** die Montageplatine (50) der elektrischen Isolierung dienende Durchbrüche (54, 55, 56) aufweist.

2. Lampensockel nach Anspruch 1, **dadurch gekennzeichnet, dass** der Innendurchmesser des ringförmigen metallischen Kontaktelementes (52) auf die Dicke bzw. den Durchmesser einer Stromzuführung (16) abgestimmt ist, so dass ein Hindurchführen der Stromzuführung (16) durch das ringförmige metallische Kontaktelement (52) möglich ist.

3. Lampensockel nach Anspruch 1, **dadurch gekennzeichnet, dass** das ringförmige metallische Kontaktelement (52) im Bereich der Ringöffnung (53) trichterförmig ausgebildet ist.

4. Hochdruckentladungslampe mit einem Lampensockel (2) und einer im Lampensockel (2) angeordneten Montageplatine (50) für elektronische Bauteile (61, 62), wobei die Montageplatine (50) ein in die Montageplatine (50) eingebettetes ringscheibenförmiges metallisches Kontaktelement (52) aufweist, **dadurch gekennzeichnet, dass** die Montageplatine (50) der elektrischen Isolierung dienende Durchbrüche (54, 55, 56) aufweist.

5. Hochdruckentladungslampe nach Anspruch 4, **dadurch gekennzeichnet, dass** eine Stromzuführung (16) der Hochdruckentladungslampe durch die Ringöffnung (53) des ringscheibenförmigen metallischen Kontaktelementes (52) hindurchgeführt und mit dem ringscheibenförmigen metallischen Kontaktelement (52) elektrisch leitend verbunden ist.

6. Hochdruckentladungslampe nach Anspruch 4, **dadurch gekennzeichnet, dass** das ringscheibenförmige metallische Kontaktelement (52) im Bereich der Ringöffnung (53) trichterförmig ausgebildet ist.

## Claims

1. Lamp base for a high-pressure discharge lamp with a mounting board (50) arranged in the lamp base (2) for electronic components (61, 62), the mounting board (50) having an annular metallic contact element (52) which is embedded in the mounting board (50), **characterized in that** the mounting board (50) has apertures (54, 55, 56) which are used for electrical insulation purposes.

2. Lamp base according to Claim 1, **characterized in that** the inner diameter of the annular metallic contact element (52) is matched to the thickness or the diameter of a power supply line (16), with the result that it is possible to pass the power supply line (16) through the annular metallic contact element (52).

3. Lamp base according to Claim 1, **characterized in that** the annular metallic contact element (52) is in the form of a funnel in the region of the annular opening (53).

4. High-pressure discharge lamp with a lamp base (2) and a mounting board (50) arranged in the lamp base (2) for electronic components (61, 62), the mounting board (50) having an annular-disc-shaped metallic contact element (52), which is embedded in the mounting board (50), **characterized in that** the mounting board (50) has apertures (54, 55, 56) which are used for electrical insulation purposes.

5. High-pressure discharge lamp according to Claim 4, **characterized in that** a power supply line (16) of the high-pressure discharge lamp is passed through the annular opening (53) of the annular-disc-shaped metallic contact element (52) and is electrically conductively connected to the annular-disc-shaped metallic contact element (52).

6. High-pressure discharge lamp according to Claim 4, **characterized in that** the annular-disc-shaped metallic contact element (52) is in the form of a funnel in the region of the annular opening (53).

## Revendications

1. Culot de lampe pour une lampe à décharge à haute pression, comprenant une platine ( 50 ) disposée dans le culot de lampe pour le montage de composants ( 61, 62 ) électroniques, la platine ( 50 ) de montage ayant un élément ( 52 ) métallique de contact annulaire incorporé dans la platine ( 50 ) de montage, **caractérisé en ce que** la platine ( 50 ) de montage a des traversées ( 54, 55, 56 ) servant d'isolant électrique.

2. Culot de lampe suivant la revendication 1, **caractérisé en ce que** le diamètre intérieur de l'élément ( 52 ) métallique de contact annulaire est adapté à l'épaisseur ou au diamètre d'une entrée ( 16 ) de courant, de sorte que l'entrée ( 16 ) de courant peut traverser l'élément ( 52 ) métallique de contact annulaire.

3. Culot de lampe suivant la revendication 1, **caractérisé en ce que** l'élément ( 52 ) métallique de contact annulaire est en forme d'entonnoir dans la partie de l'ouverture ( 53 ) annulaire.

4. Lampe à décharge à haute pression ayant un culot ( 2 ) de lampe et une platine ( 50 ) disposée dans le culot ( 2 ) de lampe pour le montage de composants ( 61, 62 ) électroniques, la platine ( 50 ) de montage ayant un élément ( 52 ) métallique de contact en forme de rondelle incorporé dans la platine ( 50 ) de montage, **caractérisée en ce que** la platine ( 50 ) de montage a des traversées ( 54, 55, 56 ) servant à isoler électriquement.

5. Lampe à décharge à haute pression suivant la revendication 4, **caractérisée en ce qu'**une entrée ( 16 ) de courant de la lampe à décharge à haute pression passe dans l'ouverture ( 53 ) annulaire de l'élément ( 52 ) métallique de contact en forme de rondelle et est reliée d'une manière conductrice de l'électricité à l'élément ( 52 ) métallique de contact en forme de rondelle.

6. Lampe à décharge à haute pression suivant la revendication 4, **caractérisée en ce que** l'élément ( 52 ) métallique de contact en forme de rondelle est en forme d'entonnoir dans la partie de l'ouverture ( 53 ) annulaire.
